# EUROPEAN PATENT APPLICATION

(11) **EP 4 578 992 A1**
(43) Date of publication of application: **02.07.2025**
(21) Application number: 23220552.6
(22) Date of filing: 28.12.2023
(51) Int. Cl.: C23C 28/04, C23C 14/06, C23C 28/00, C23C 30/00

(54) **WORKPIECE HAVING A HARD MATERIAL LAYER**

(71) Applicant: VOESTALPINE EIFELER VACOTEC GMBH, 40549 Düsseldorf (DE)
(72) Inventor: EVERTZ, Simon, 40549 Düsseldorf (DE); ZIMMERMANN, Uwe, 40549 Düsseldorf (DE); HOLZAPFEL, Damian, 40549 Düsseldorf (DE)
(74) Representative: Lambsdorff & Lange Patentanwälte Partnerschaft mbB

(57) **Abstract**

A workpiece includes a substrate and a hard material layer disposed over the substrate. The hard material layer comprises at least one first metal nitride layer and at least one second metal nitride layer disposed one over the other. The first metal nitride layer has a composition (Tiₐ, Si_{b}, Z_{z}) CₚN₁₋ₚ with optionally added alloying elements Z = (Ni,Ta,Mo,W,Nb,Al), with 0 ≤ Ni ≤ 9 at.%, 0 ≤ Ta ≤ 15 at.%, 0 ≤ Mo ≤ 15 at.%, 0 ≤ W ≤ 10 at.%, 0 ≤ Nb ≤ 15 at.%, 0 ≤ Al ≤ 40 at.%. The second metal nitride layer has a composition (Al_{c}, Ti_{d}, Xₓ, Bₑ)CₚN₁₋ₚ with optionally added alloying elements X = (Ni,Ta,Si,Mo,W,Nb), with 0 ≤ Ni ≤ 20 at.%, 0 ≤ Ta ≤ 15 at.%, 0 ≤ Si ≤ 30 at.%, 0 ≤ Mo ≤ 12 at.%, 0 ≤ W ≤ 10 at.%, 0 ≤ Nb ≤ 15 at.%, wherein 0.50 ≤ a ≤ 0.90, 0.05 ≤ b ≤ 0.32, 0.30 ≤ c ≤ 0.72, 0.20 ≤ d ≤ 0.50, 0.01 ≤ e ≤ 0.07. The compositions of the first metal nitride layer and the second metal nitride layer are approximately stoichiometric, C can be partially or completely replaced by O, and 0.00 ≤ p ≤ 0.05 for the first metal nitride layer and 0.00 ≤ p ≤ 0.05 for the second metal nitride layer.

## Description

### Technical Field

This disclosure relates to a workpiece having a hard material layer formed over a substrate, and in particular to a workpiece used as a tool for machining or forming operations.

### Background

The use of protective coatings on tools for machining materials of high hardness, in particular for cutting and milling metal materials of high hardness, is known. Such tools compromise a substrate and a hard material coating to protect the substrate, to extend the lifetime of the tool and to improve its operational performance.

Since many years, efforts have been made to improve the tool performance, for example, wear resistance. The most common coating is cubic TiN. However, due to its moderate oxidation resistance at elevated temperatures, alloying Al in (Ti,Al)N was carried out. Today, (Al,Ti)N-based coatings are among the most common hard and protective coating materials used in hard metal cutting applications. The cubic structure of (Al,Ti)N combines attractive mechanical properties such as high hardness and improved temperature and oxidation resistance.

The technological benefits of (Al,Ti)N and its excellent physical properties, especially at elevated temperatures, is partly explained in terms of a spinodal decomposition process during which cubic (Al,Ti)N decomposes iso-structurally into coherent cubic c-AlN and c-TiN-enriched domains. The combination of elastic properties and a lattice mismatch between coherent c-AlN and c-TiN-enriched domains leads to significant age hardening. During the age-hardening process, the hardness of (Al,Ti)N thin layers has been shown to increase up to 10%.

Annealing at higher temperatures leads to the transformation of c-AlN into the thermodynamically stable hexagonal (also referred to as wurtzite) structure, h-AlN, resulting in a dual phase structure comprising c-TiN and h-AlN with reduced mechanical properties.

Today the cutting/milling industry seeks solutions for economic and high productivity manufacturing possibilities. To meet these demands there is a need for new materials with advanced properties to improve tool life during operation.

In the metal cutting/milling tool industry a major part of these efforts is focused on the wear behavior of the cutting tools. Typically, a high productivity process results in high tool temperatures and hence, a coating material with a high temperature wear resistance is advantageous.

(Al,Ti)N-based coatings are frequently used in the art to reduce the wear and increase the lifetime of a tool. However, the composition (Al,Ti)N is metastable and decomposes at elevated temperatures (about 900°C) into c-TiN and h-AlN. For a high temperature suitability, it may therefore be desirable to shift this decomposition to higher temperatures (i.e., to improve the thermal stability of the coating).

Tools considered herein are subjected to thermal load, mechanical load, and chemical interaction. In addition to high thermal stability, several other properties of the hard material coating may be important in practice. In many applications, the material of the coating should have a low thermal conductivity in order to allow higher machining speeds and longer tool lifetime (i.e., to keep the thermal load away from the tool substrate). Further aspects which are of importance are a high fracture toughness, a high abrasion resistance, a low surface roughness and a low adhesion to the metal to be machined. Moreover, the protective coating should have excellent adhesion to the substrate in order to avoid chipping. Other aspects, which may be of importance depending on the application, are a high resistance to oxidation, a low defect concentration and low intrinsic stress. In some applications, the hard material coating should have a good suitability for de-coating, allowing the tool to be recoated and used multiple times.

### Summary

According to an aspect of the disclosure a workpiece comprises a substrate and a hard material layer disposed over the substrate. The hard material layer comprises at least one first metal nitride layer and at least one second metal nitride layer disposed one over the other. The first metal nitride layer has a composition (Tiₐ,Si_{b},Z_{z})CₚN₁₋ₚ with optionally added alloying elements Z = (Ni,Ta,Mo,W,Nb,Al), with 0 ≤ Ni ≤ 9 at.%, 0 ≤ Ta ≤ 15 at.%, 0 ≤ Mo ≤ 15 at.%, 0 ≤ W ≤ 10 at.%, 0 ≤ Nb ≤ 15 at.%, 0 ≤ Al ≤ 40 at.%. The second metal nitride layer has a composition (Al_{c},Ti_{d},Xₓ,Bₑ)CₚN₁₋ₚ with optionally added alloying elements X = (Ni,Ta,Si,Mo,W,Nb), with 0 ≤ Ni ≤ 20 at.%, 0 ≤ Ta ≤ 15 at.%, 0 ≤ Si ≤ 30 at.%, 0 ≤ Mo ≤ 12 at.%, 0 ≤ W ≤ 10 at.%, 0 ≤ Nb ≤ 15 at.%, wherein 0.50 ≤ a ≤ 0.90, 0.05 ≤ b ≤ 0.32, 0.30 ≤ c ≤ 0.72, 0.20 ≤ d ≤ 0.50, 0.01 ≤ e ≤ 0.07. The compositions of the first metal nitride layer and the second metal nitride layer are approximately stoichiometric, C can be partially or completely replaced by O, and 0.00 ≤ p ≤ 0.05 for the first metal nitride layer and 0.00 ≤ p ≤ 0.05 for the second metal nitride layer.

According to another aspect of the disclosure, a method of manufacturing a workpiece comprising a substrate and a hard material layer disposed over the substrate as described above uses physical vapor deposition and/or chemical vapor deposition to generate the hard material layer over the substrate.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a perspective view of an exemplary tool used for hard metal cutting or milling.
Figure 2 illustrates X-ray diffraction (XRD) diagrams of 4 examples of hard material layer compositions.
Figures 3A-3C illustrate examples of a hard material layer on a substrate of a workpiece.
Figure 4 illustrates various layer stack architectures in connection with Figures 3A-3C.
Figure 5 illustrates tool lifetime results for several inventive and non-inventive examples.

### Detailed description

The words "over" or "on" or "beneath" with regard to a part, element or material layer formed or located or disposed or arranged or placed "over" or "on" or "beneath" a surface may be used herein to mean that the part, element, or material layer be located (e.g. placed, formed, arranged, disposed, etc.) "directly on" or "directly under", e.g. in direct contact with, the implied surface. The word "over" or "on" or "beneath" used with regard to a part, element, or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or material layers being arranged between the implied surface and the part, element or material layer.

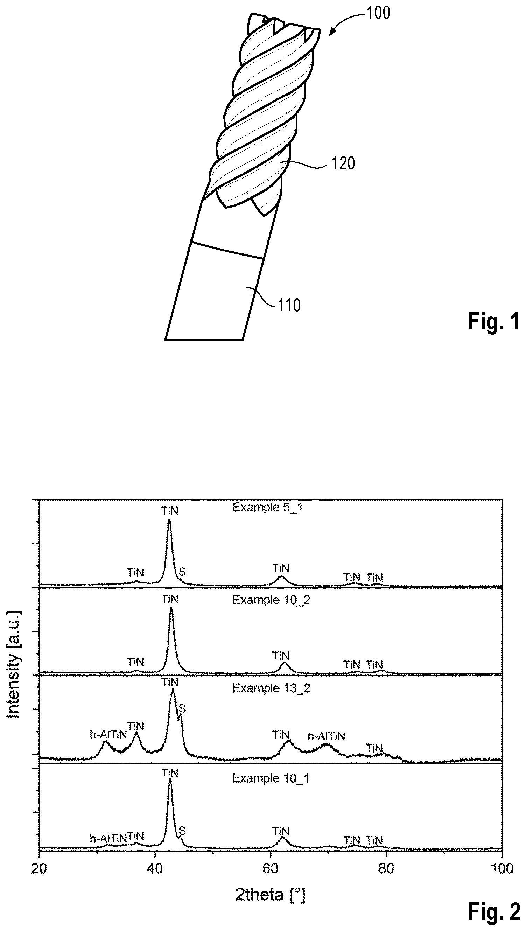

Figure 1 illustrates an exemplary tool or workpiece 100 used for metal cutting or milling operations. In the example shown, the workpiece 100 is an end mill. However, other tools such as, e.g., shaft cutters, etc., for machining hard materials may be examples for workpieces 100 disclosed herein.

In particular, workpieces 100 described herein may be designed to be used in metal machining or metal cutting/milling applications, in which high temperatures greater than 900°C may be created and/or are present. Hard metals to be cut/milled by the tools described herein may include steel, e.g., of a hardness equal to or greater than 55 HRC (Rockwell C Hardness), titanium, nickel-based alloys such as, e.g., Inconel, etc.

The workpiece 100 includes a substrate 110 and a hard material layer 120 disposed over the substrate 110. For example, the substrate 110 may be made of metal, in particular steel, e.g. HSS, cemented carbide (CC), or MC90. The hard material layer 120 is used as a coating to protect the substrate 110 and thereby to extend the lifetime of the workpiece 100 (e.g., tool) as well as to improve its performance.

During operation, the workpiece 100 may suffer wear and/or damage such as, e.g., cutting edge rounding, flank wear, chipping, and cratering, that can occur over time during operation of the workpiece 100. To avoid such damages, or for other reasons, several aspects related to the hard material layer 120 may be important:

The main mechanical properties of interest of the hard material layer 120 may be hardness and fracture toughness. Both are to be increased, which is difficult because an increase in hardness typically reduces fracture toughness and vice versa.

In addition, a reduction in thermal conductivity (κ) may be particularly desirable because the lower the thermal conductivity, the better the protection of the substrate 110 from thermal damage.

Further, for the hard material layer 120, an increase in phase stability (i.e., thermal stability), a reduction in compressive lattice stress caused by ion bombardment during deposition of the hard material layer and an improvement in mechanical properties may be desirable.

These and other properties are strongly dependent on the chemical and physical parameters of the hard material layer, especially on its composition and on its architecture of layer structure.

According to an aspect of the disclosure, the hard material layer 120 may comprise at least one first metal nitride layer and at least one second metal nitride layer disposed one over the other. By the at least two-layer architecture of the hard material layer 120, the hard material layer 120 can be provided with multiple and different (and, e.g., wear-dependent) properties in terms of the above-mentioned mechanical, thermal and/or other demands.

The composition of the first metal nitride layer is different than the composition of the second metal nitride layer. More specifically, the first metal nitride layer may have a composition (Tiₐ,Si_{b},Z_{z})CₚN₁₋ₚ with 0.50 ≤ a ≤ 0.90, 0.05 ≤ b ≤ 0.32, and optionally added alloying elements Z = (Ni,Ta,Mo,W,Nb,Al). The second metal nitride layer may have a composition (Al_{c},Ti_{d},Xₓ,Bₑ)CₚN₁₋ₚ, with 0.30 ≤ c ≤ 0.72, 0.20 ≤ d ≤ 0.50, 0.01 ≤ e ≤ 0.07, and optionally added alloying elements X = (Ni,Ta,Si,Mo,W,Nb).

Here and in the following, a notation is used in which the indices of the elements placed in parentheses refer to the content of the elements in the so-called metal sub-lattice of the composition, i.e. to the composition term placed in parentheses. That is, the indices (here: a, b, z for the first layer, and c, d, x, e for the second layer) of the elements placed in parenthesis add up to 1 (corresponding to 100 at.%).

Hence, the composition (Tiₐ,Si_{b},Z_{z})CₚN₁₋ₚ with optionally added alloying elements Z = (Ni,Ta,Mo,W,Nb,Al) of the first metal nitride layer can also be written as (Tiₐ,Si_{b},Ni_{z1},Ta_{z2},Mo_{z3},W_{z4},Nb_{z5},Al_{z6})CₚN₁₋ₚ, with a+b+z = 1 and z1+z2+z3+z4+z5+z6 = z (with, e.g., z1=z2=z3=z4=z5=z6 = 0, if no (optional) alloying element is added). Similarly, the composition (Al_{c},Ti_{d},Xₓ,Bₑ)CₚN₁₋ₚ, with optionally added alloying elements X = (Ni,Ta,Si,Mo,W,Nb) of the second metal nitride layer can also be written as (Al_{c},Ti_{d},Niₓ₁,Taₓ₂,Siₓ₃,Moₓ₄,Wₓ₅,Nbₓ₆,Bₑ)CₚN₁₋ₚ, with c+d+x+e = 1 and x1+x2+x3+x4+x5+x6 = x (with, e.g., x1=x2=x3=x4=x5=x6 = 0, if no (optional) alloying element is added).

It is to be noted that other notations such as those without indices and/or without commas for the metal sub-lattice (e.g., (TiSiZ)N or TiSiZN for (Tiₐ,Si_{b},Z_{z})N) are also common in the art. Further, as can be seen from the above, not all elements of the metal sub-lattice need to be metals.

To reduce the length of notation, the indices of the optional elements are not included in the notation. That is, the first metal nitride layers' composition of (Tiₐ,Si_{b},Z_{z})CₚN₁₋ₚ with optionally added alloying elements Z = (Ni,Ta,Mo,W,Nb,Al) in the amount of 0 ≤ Ni ≤ 9 at.%, 0 ≤ Ta ≤ 15 at.%, 0 ≤ Mo ≤ 15 at.%, 0 ≤ W ≤ 10 at.%, 0 ≤ Nb ≤ 15 at.%, 0 ≤ Al ≤ 40 at.%, corresponds to (Tiₐ,Si_{b},Ni_{z1},Ta_{z2},Mo_{z3},W_{z4},Nb_{z5},Al_{z6})CₚN₁₋ₚ, with 0 ≤ z1 ≤ 0.09, 0 ≤ z2 ≤ 0.15, 0 ≤ z3 ≤ 0.15, 0 ≤ z4 ≤ 0.10, 0 ≤ z5 ≤ 0.15 and 0 ≤ z6 ≤ 0.40. Correspondingly, the second metal nitride layer's composition of (Al_{c},Ti_{d},Xₓ,Bₑ)CₚN₁₋ₚ, with optionally added alloying elements X = (Ni,Ta,Si,Mo,W,Nb) in the amount of 0 ≤ Ni ≤ 20 at.%, 0 ≤ Ta ≤ 15 at.%, 0 ≤ Si ≤ 30 at.%, 0 ≤ Mo ≤ 12 at.%, 0 ≤ W ≤ 10 at.%, 0 ≤ Nb ≤ 15 at.% corresponds to (Al_{c},Ti_{d},Niₓ₁,Taₓ₂,Siₓ₃,Moₓ₄,Wₓ₅,Nbₓ₆,Bₑ)CₚN₁₋ₚ, with 0 ≤ x1 ≤ 0.20, 0 ≤ x2 ≤ 0.15, 0 ≤ x3 ≤ 0.30, 0 ≤ x4 ≤ 0.12, 0 ≤ x5 ≤ 0.10, 0 ≤ x6 ≤ 15 at.%.

Further, it is to be noted that irrespective of the composition of the metal sub-lattice (i.e., the composition term placed in parenthesis), the compositions of the first metal nitride layer and the second metal nitride layer are approximately stoichiometric, i.e. about 50 at.% (ideally, exactly 50% at.%) of the atoms of the total lattice is the non-metal sub-lattice CₚN₁₋ₚ and the rest is the metal sub-lattice (term in parenthesis). However, as the compositions may slightly deviate from stoichiometry, the content of CₚN₁₋ₚ may be, e.g., in a range of 45 to 55 at.%, in particular 48 to 52 at.% of the total lattice, which is still be referred to as an "approximately (but not ideally) stoichiometric composition" herein.

The part of the composition which is the non-metal sub-lattice is CₚN₁₋ₚ. In some examples, the non-metal sub-lattice consists of N, i.e. p = 0. In other examples, however, N may be substituted to a low extent by C. In this case, the non-metal sub-lattice is CₚN₁₋ₚ, with p ≤ 0.05. This may apply independently to the first metal nitride layer and/or the second metal nitride layer. That is, the C content p of the first metal nitride layer and/or the second metal nitride layer may be different.

Further, C can, e.g., be partly or completely replaced by O within the limit given for p. That is, the non-metal sub-lattice can generally be written as MₚN₁₋ₚ, with M is O and/or C. However, for ease of notation (to avoid another variable M), throughout this disclosure, the non-metal sub-lattice is written as CₚN₁₋ₚ, bearing in mind that C can always be partly or completely substituted by O and thus replaced by M in the non-metal sub-lattice notation. In the non-metal sub-lattice notation, the index 1 corresponds to 100 at.% of the non-metal sub-lattice.

In particular, it may be advantageous if the first metal nitride layer contains C (i.e., p > 0) while the second metal nitride layer may or may not contain C (i.e., p > 0 or p = 0). C increases the hardness and improves lubricating properties, which are particularly advantageous for the first metal nitride layer.

Further, it may be preferred that the first metal nitride layer has a content p of C which increases along a direction facing away from the substrate. The C-gradient may be helpful because C is particularly beneficial at the upper surface of the hard material layer 120 to improve hardness and lubricating properties there.

The effects of the elements of the metal sub-lattice in relation to their content are described below.

Aluminum (Al) is a main group metal. Al forms preferably the wurtzite (hexagonal) AlN structure with nitrogen (also referred to as h-AlN). Al increases the oxidation resistance of the cubic transition metal (TM) aluminum nitride structure (referred to in the following as c-(TM,Al)N structure), as a protective Al₂O₃ scale can form. On the other hand, Al mobility (diffusion) is the main effect for the decomposition of the material system at elevated temperatures.

In the first metal nitride layer, Al may be, e.g., used in a range between 0 at.% and 40 at.%. Preferably, at least 1 at.% Al and up to 35 at.% Al or up to 28 at.% Al may be used to obtain increased oxidation resistance without deterioration of the mechanical properties.

In the second metal nitride layer, Al is used in a range between 30 at.% and 72 at.%. Preferably, 65 at.% Al may be used, as this offers the highest hardness. Above 69 at.% Al, the thermal stability decreases significantly. Below 30 at.% Al, the oxidation resistance decreases.

Titanium (Ti) is a transition metal (TM). Ti forms preferably with nitrogen the cubic TiN structure. Ti strains the atomic lattice and increases the phase stability (as is needed for high temperature operations). On the other hand, Ti decreases the oxidation resistance of the c-(TM,Al)N structure, as a porous TiO₂ scale can form. Ti oxidation can be one of the main effects for coating failure of the material system at elevated temperatures.

The first metal nitride layer is a Ti-based layer, Al is optional. Therefore, high Ti contents are used. In this layer, Ti forms the cubic TiN structure with N and exhibits high hardness, wear and corrosion protection. With oxygen, TiN preferentially oxidizes to tetragonal TiO₂. As this oxide scale contains pores, the formation of TiO₂ has negative effect on the coating properties. Alloying can improve oxidation resistance by inducing the formation of dense oxide scale and oxides with different crystal structure. In this layer, Ti may be used in a range between 50 at.% and 90 at.%. Preferably, between 65 and 82 at.% Ti may be used, as this offers the best mechanical properties and corrosion resistance. Above 85 at.% Ti, the oxidation resistance decreases significantly. Below 60 at.% Ti, the mechanical properties deteriorate significantly.

The second metal nitride layer contains Al. It may be Al-based, i.e. the content of Al may, e.g., be higher than the content of Ti. In this layer, below 20 at.% of Ti, the oxidation of Ti (during operation) may be more detrimental than the stabilization of the cubic phase (during deposition), i.e. the negative effect may be larger than the positive effect. A preferred range of Ti may be between 23 and 39 at.%. In some examples, about 30 at.% Ti may be used as this offers the highest hardness and wear protection. Above 39 at.% Ti, the oxidation resistance decreases slightly. Above 50 at.%, the wear resistance is insufficient for milling applications.

In the first metal nitride layer, Ti is used in a range between 50 at.% and 90 at.%, preferably, in a range between 60 at.% and 85 at.%. In the second metal nitride layer, the content of Ti is lower as in the first metal layer, namely in a range between 20 at.% and 50 at.%, preferably in a range between 23 at.% and 39 at.%.

Silicon (Si) is a main group non-metal. Si forms preferably the amorphous Si₃N₄ phase with nitrogen. Si improves the oxidation resistance of the c-(TM,Al)N structure drastically, as a mixture of SiO₂ and TiO₂ forms an oxygen diffusion barrier at the surface of the hard material layer. In the bulk hard material layer, the formation of the SiNₓ tissue phase is one of the main effects for enhanced hardness of the c-(TM,Al)N structure. On the other hand, Si reduces the crystallite (grain) size, thereby decreasing the thermal conductivity. Si segregates to grain boundaries, thereby limiting material transport.

In the first metal nitride layer, Si is used in a range between 5 at.% and 32 at.%, preferably, in a range between 10 at.% and 30 at.%. Preferably, about 20 at.% Si may be used as this offers the highest hardness and good oxidation resistance.

In the second metal nitride layer, the content of Si, if any, may be (much) lower than in the first metal nitride layer. In the second metal nitride layer, Si may be used in a range between 0 at.% and 30 at.%, in particular in a range between 1 at.% and 20 at.%. Preferably, about 10 at.% Si may be used as this offers the highest hardness. Above 15 at.% Si, the oxidation resistance still increases, however the hardness may decrease. Above 30 at.%, the decrease in hardness may be too significant. Below 1 at.% Si the oxidation resistance does not improve by the addition of Si.

Nickel (Ni) is a transition metal (TM). Ni forms preferentially the hexagonal Ni₃N structure with nitrogen. Small amounts of Ni are soluble in the cubic c-(TM,Al)N structure. Ni strongly influences the microstructure. Up to 2 at.% Ni forms a fine columnar microstructure. Above 4 at.% a fine equiaxed microstructure is formed, thereby decreasing thermal conductivity of the metal nitride layer towards the tool.

At about 4 at.% Ni, a fine microstructure and good mechanical properties are obtained. Above 7 at.% Ni, the mechanical properties may deteriorate. Below 2 at.% Ni, the nanocrystalline equiaxed microstructure does not form. In the first metal nitride layer, Ni may be used in a range between 0 at.% and 9 at.%, preferably, in a range between 1 at.% and 6 at.%. In the second metal nitride layer, the content of Ni, if any, may be higher than in the first metal nitride layer. In the second metal nitride layer, Ni may be used in a range between 0 at.% and 20 at.%, in particular in a range between 2 at.% and 12 at.%.

Molybdenum (Mo) is a transition metal (TM). Mo forms preferably the Mo₂N phase with nitrogen. Mo improves the wear resistance of the c-(TM,Al)N structure drastically, as a lubricating oxide of MoO₃ forms that enables less friction during operation. That is, Mo reduces the coefficient of friction, enabling less material adhesion on the hard material layer (i.e., the protective coating).

In the first metal nitride layer, Mo may be used in a range between 0 at.% and 15 at.%, preferably, in a range between 1 at.% and 5 at.%. In the second metal nitride layer, the content of Mo, if any, may, e.g., be similar than in the first metal nitride layer. More specifically, in the second metal nitride layer, Mo may be used in a range between 0 at.% and 12 at.%, in particular in a range between 1 at.% and 7 at.%.

Tungsten (W) is a transition metal (TM). W forms preferentially with nitrogen the trigonal W₂N phase. W improves the fracture toughness of the c-(TM,Al)N structure. W reduces the coefficient of friction and reduces wear rates. Moreover, W forms a lubricating oxide.

In both metal nitride layers, W may be used in a range between 0 at.% and 10 at.%, preferably in a range between 1 at.% and 7 at.%. It has been shown that about 5 at.% W may be used as best combination of hardness and oxidation resistance. Above 10 at.% W, the thermal stability decreases. Above 5 at.% W, the wear resistance does not improve.

Tantalum (Ta) is a transition metal (TM). Ta forms preferentially with nitrogen the hexagonal TaN phase. Ta increases the phase stability and retains hardness at high temperatures. Ta improves wear behavior. Ta enhances oxidation resistance by inducing a dense rutile TiO₂ layer.

In both metal nitride layers, Ta may be used in a range between 0 at.% and 15 at.%, preferably in a range between 1 at.% and 12 at.%. It has been shown that about 10 at.% Ta offers the best oxidation resistance. Below 2 at.% Ta, the oxidation resistance does not improve.

Niobium (Nb) is a transition metal (TM). Nb forms with nitrogen preferably the hexagonal NbN phase. Nb may improve the wear resistance of the c-(TM,Al)N structure drastically, as the hardness increases with Nb addition. Further, Nb increases the ductility of the c-(TM,Al)N structure. Nb increases the thermal stability of c-(TM,Al)N significantly. Nb increases oxidation resistance and forms a lubricating oxide.

In both metal nitride layers, Nb may be used in a range between 0 at.% and 15 at.%, preferably in a range between 1 at.% and 13 at.% (first metal nitride layer) and 1 at.% and 12 at.% (second metal nitride layer), respectively. In some examples, about 3 at.% Nb may be used as this has shown to offer the highest hardness and oxidation resistance. Above 5 at.% Nb, the oxidation resistance decreases slightly, above 8 at.% it decreases significantly. Above 12 at.%, no improvement is obtained by raising the Nb concentration.

Boron (B) is a main group non-metal. B forms preferably the hexagonal BN phase with nitrogen. B reduces the crystallite (grain) size, thereby decreasing the thermal conductivity. B improves the wear resistance of the c-(TM,Al)N structure drastically, as the hardness and elastic modulus improve with B addition.

In the second metal nitride layer, B is used in a range between 1 at.% and 7 at.%, in particular in a range between 2 at.% and 6 at.%. In some examples, about 3 at.% B may be used, as this has shown to offer the highest hardness. Above 6 at.% B, the thermal stability decreases significantly. Below 1 at.% B, the wear resistance does not improve by the addition of B.

Nitrogen (N) is a main group non-metal. It is part of the non-metal sub-lattice. N increases the mechanical properties of the metals.

It is possible to form nitrides stoichiometric (50 at.% of the total lattice), over-stoichiometric (more than 50 at.% of the total lattice) or under-stoichiometric (less than 50 at.% of the total lattice). Both latter scenarios (over-stoichiometric and under-stoichiometric nitrides) may decrease the mechanical properties and may decrease the phase stability as vacancies (metal vacancies if nitrogen is over-stoichiometric, and nitrogen vacancies if nitrogen is under-stoichiometric) form. It is also possible to substitute N with oxygen and/or carbon to a small extent.

Hence, preferentially a stoichiometric nitride may be targeted as this offers the highest elastic modulus. Above 51 at.% N, the thermal stability decreases. Below 49 at.% N, the mechanical properties decrease. A preferred range of N may be between 45 and 55 at.%, more preferably between 48 and 52 at.%, as this may promote the elastic modulus and hardness (which, however, can also be affected by other elements as described above).

Carbon (C) is a main group non-metal. It is part of the non-metal sub-lattice.

C increases the hardness of the coating. Additionally, C may be helpful because C provides a lubricating effect on the surface of the tool. Above a certain limit, C can no longer be incorporated, i.e. it is no longer soluble. If too much C is added, the coating becomes more brittle. That is, the fracture toughness decreases (due to the increasing brittleness), and crack propagation can occur more easily. Therefore, p is at most 0.05.

Oxygen (O) is a main group non-metal. It is part of the non-metal sub-lattice.

O increases oxidation resistance and thermal stability. O improves wear resistance and enhances lifetime until thermal fatigue. However, formation of oxides deteriorates the properties. Therefore, p is at most 0.05.

According to the above, a hard material layer without Chromium (Cr) is provided. To summarize the main effects, alloying the (Ti,Si)N layer and/or the (Al,Ti,B)N layer with Si, Mo, Ni, Ta, Nb, or B (only used in the (Al,Ti,B)N layer) increases the phase stability, the oxidation resistance but reduces the thermal conductivity. Addition of Ti strains the atomic lattice and increases phase stability. Addition of Si, B (only used in the (Al,Ti,B)N layer), and Ni reduces crystallite size which reduces thermal conductivity. B increases hardness, wear resistance and lowers thermal conductivity. Ni increases hardness, toughness, and wear resistance. Mo forms a lubricious oxide (MoO₃) that enables less friction during operation. W has a similar effect as Mo and is, in particular, also effective to form a lubricious oxide. Si segregates to grain boundaries and limits thereby material transport. Ta induces a dense rutile TiO₂ oxide layer. Nb improves tribological properties. Nanocrystals and interlayer in the coating reduce the thermal conductivity.

Table 1 and Table 2 summarize exemplary chemical compositions and preferred boundaries of the metal sub-lattice of the first metal nitride layer and the second metal nitride layer, respectively, according to the disclosure (upper and lower limits, preferred upper and lower limits, specifically preferred upper and lower limits). Additional (optional) upper and lower limits for each element (within the given upper-to-lower limit range) may be derived by subtracting limits as set out in the respective table of all other elements from 100 at.% (i.e., each single element may represent the rest with regard to ranges specified for the other elements).

**Table 1: Boundaries and exemplary chemical compositions of the first metal nitride layer (TiSiZ)CN (in at.% of the metal sub-lattice)**

| | **Al** | **Ti** | **Si** | **Ni** | **Mo** | **W** | **Nb** | **Ta** |
|---|---|---|---|---|---|---|---|---|
| **Upper limit** | 40 | 90 | 32 | 9 | 15 | 10 | 15 | 15 |
| **Pref. upper limit** | 35 | 85 | 30 | 6 | 5 | 7 | 13 | 12 |
| **Spec. pref. upper limit** | 28 | 82 | 27 | 4 | 3 | 6 | 9 | 10 |
| **Spec. pref. lower limit** | 1 | 65 | 15 | 1 | 1 | 1 | 3 | 4 |
| **Pref. lower limit** | 1 | 60 | 10 | 1 | 1 | 1 | 1 | 1 |
| **Lower limit** | 0 | 50 | 5 | 0 | 0 | 0 | 0 | 0 |

**Table 2: Boundaries and exemplary chemical compositions of the second metal nitride layer (AlTiXB)CN (in at.% of the metal sub-lattice)**

| | **Al** | **Ti** | **Si** | **Ni** | Mo | W | Nb | Ta | B |
|---|---|---|---|---|---|---|---|---|---|
| **Upper limit** | 72 | 50 | 30 | 20 | 12 | 10 | 15 | 15 | 7 |
| **Pref. upper limit** | 69 | 39 | 20 | 12 | 7 | 7 | 12 | 12 | 6 |
| **Spec. pref. upper limit** | 65 | 34 | 15 | 10 | 6 | 6 | 8 | 10 | 5 |
| **Spec. pref. lower limit** | 55 | 25 | 2 | 2 | 1 | 1 | 3 | 4 | 2 |
| **Pref. lower limit** | 50 | 23 | 1 | 2 | 1 | 1 | 1 | 1 | 2 |
| **Lower limit** | 30 | 20 | 0 | 0 | 0 | 0 | 0 | 0 | 1 |

### EXAMPLES

In Table 3, examples of compositions of the first metal nitride layer are set out.

**Table 3: Example chemical compositions of the first metal nitride layer (TiSiZ)CN (in at.% of the metal sub-lattice)**

| **Examples** | **Al** | **Ti** | **Si** | **Ni** | **Mo** | **W** | **Nb** | **Ta** |
|---|---|---|---|---|---|---|---|---|
| **No. 1_1** | 9 | 76 | 14 | 1 | 0 | 0 | 0 | 0 |
| **No. 2_1** | 0 | 78 | 19 | 3 | 0 | 0 | 0 | 0 |
| **No. 3_1** | 9 | 76 | 12 | 2 | 0 | 0 | 1 | 0 |
| **No. 4_1** | 0 | 79 | 17 | 4 | 0 | 0 | 0 | 0 |
| **No. 5_1** | 0 | 81 | 16 | 1 | 2 | 0 | 0 | 0 |
| **No. 6_1** | 0 | 77 | 15 | 1 | 0 | 0 | 0 | 7 |
| **No. 7_1** | 0 | 81 | 17 | 2 | 0 | 0 | 0 | 0 |
| **No. 8_1** | 0 | 83 | 16 | 1 | 0 | 0 | 0 | 0 |

In all examples No. 1_1 to No. 8_1, p = 0.01, i.e. the non-metal sub-lattice contains C_{0.01}N_{0.99}.

In Table 4, examples of compositions of the second metal nitride layer are set out.

**Table 4: Example chemical compositions of the second metal nitride layer (AlTiXB)CN (in at.% of the metal sub-lattice)**

| **Examples** | **Al** | **Ti** | **Si** | **Ni** | **Mo** | **W** | **Nb** | **Ta** | **B** |
|---|---|---|---|---|---|---|---|---|---|
| **No. 1_2** | 57 | 39 | 0 | 1 | 0 | 0 | 0 | 0 | 3 |
| **No. 2_2** | 60 | 35 | 0 | 0 | 3 | 0 | 0 | 0 | 2 |
| **No. 3_2** | 63 | 31 | 0 | 0 | 0 | 0 | 0 | 4 | 2 |
| **No. 4_2** | 61 | 32 | 0 | 2 | 0 | 0 | 0 | 0 | 5 |
| **No. 5_2** | 57 | 37 | 0 | 4 | 0 | 0 | 0 | 0 | 2 |
| **No. 6_2** | 52 | 35 | 2 | 3 | 0 | 2 | 0 | 0 | 6 |
| **No. 7_2** | 55 | 31 | 0 | 8 | 3 | 0 | 0 | 0 | 3 |
| **No. 8_2** | 53 | 36 | 2 | 3 | 0 | 0 | 0 | 0 | 6 |
| **No. 9_2** | 58 | 33 | 0 | 3 | 0 | 0 | 4 | 0 | 2 |
| **No. 10_2** | 54 | 41 | 0 | 3 | 0 | 0 | 0 | 0 | 2 |
| **No. 11_2** | 60 | 29 | 0 | 3 | 4 | 0 | 0 | 0 | 4 |
| **No. 12_2** | 59 | 36 | 0 | 3 | 0 | 0 | 0 | 0 | 2 |

In all examples No. 1_2 to No. 12_2, p = 0.04, i.e. the non-metal sub-lattice contains C_{0.04}N_{0.96}.

In Table 5, non-inventive examples of compositions of the first metal nitride layer are set out.

**Table 5: Non-inventive examples of chemical compositions of the first metal nitride layer (TiSiZ)CN (in at.% of the metal sub-lattice)**

| **Non-invent. Examples** | **Al** | **Ti** | **Si** | **Ni** | **Mo** | **W** | **Nb** | **Ta** |
|---|---|---|---|---|---|---|---|---|
| **No. 9_1** | 0 | **48** | **50** | 2 | 0 | 0 | 0 | 0 |
| **No. 10_1** | 0 | 75 | 12 | **13** | 0 | 0 | 0 | 0 |

In Table 6, non-inventive examples of compositions of the second metal nitride layer are set out.

**Table 6: Non-inventive examples of chemical compositions of the second metal nitride layer (AlTiXB)CN (in at.% of the metal sub-lattice)**

| **Examples** | **Al** | **Ti** | **Si** | **Ni** | **Mo** | **W** | **Nb** | **Ta** | **B** |
|---|---|---|---|---|---|---|---|---|---|
| **No. 13_2** | **74** | 21 | 0 | 2 | 0 | 0 | 0 | 0 | 3 |
| **No. 14_2** | 52 | 24 | 0 | **23** | 0 | 0 | 0 | 0 | 1 |
| **No. 15_2** | 54 | 34 | 0 | 3 | 0 | 0 | 0 | 0 | **9** |
| **No. 16_2** | **2** | **77** | 20 | 0 | 0 | 0 | 0 | 0 | 1 |

In Tables 5 and 6, composition values that fall outside the ranges of Tables 1 and 2, respectively, are in bold. In Example No. 9_1, the Ti content is lower and the Si content is higher than laid out in Table 1. Example No. 10_1 exhibits an Ni content higher than laid out in Table 1. Examples Nos. 13_2 to 16_2 exhibit Al, Ni, B and Al contents, respectively, which fall outside the boundaries of Table 2.

Figure 2 illustrates X-ray diffraction (XRD) diagrams (diffractograms) of inventive Examples 5_1, 10_2 and non-inventive Examples 13_2, 10_1. Peaks in the diffractograms (intensity in arbitrary units versus twice the theta angle) were characterized for c-TiN (which represents the desired cubic/fcc phase) with reference to the Crystallography Open Database (COD), the corresponding dataset having the number COD-9008619, and for h-AlN (which is the undesired hexagonal phase) according to Chen et al., Surf. Coat. Techn. 206 (2012) 2954-2960. As apparent from Figure 2, the hard material layer of Examples 5_1 and 10_2 (upper diffractogram) exhibits cubic phases only, while the hard material layer of Examples 13_2 and 10_1 (lower diffractogram) exhibits both the cubic phase and, to some extent, the unwanted hexagonal phase.

Generally, a hard material layer in accordance with the disclosure may preferably have only cubic crystalline phases or, optionally, additionally a hexagonal phase (h-AlN) wherein the hexagonal phase fraction is less than 0.5 vol.%, preferably 0.2 vol.%, measured by XRD by ratio of peak areas. Measurements apply for Cu-Kₐₗₚₕₐ-Radiation, grazing angle of incidence of 1.5°, "S" denotes the substrate.

Milling-tests were performed under cold air cooling on a milling workpiece (tool) having a hard material layer that contains an inventive or a non-inventive first and second metal nitride layer combination. The hard metal which was milled by the tool described below was W360 steel (Böhler) having a Rockwell C hardness of 55 HRC. The following milling parameters were used:
Tool: Cemented Carbide shaft mill
Shaft diameter d = 10 mm
Number of teeth z = 6
Feed per tooth fz = 0.025 mm
Cutting speed vc = 95 m/min
Feed speed vf = 454 mm/min
Cutting width ae = 0.5 mm
Cutting depth ap = 5 mm.

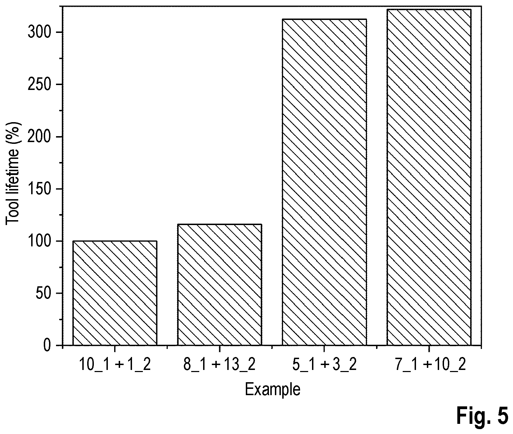

A milling test stopping criteria for tool lifetime measurements was set to a given wear limit. Figure 5 illustrates tool lifetime results for two inventive Examples of first and second metal nitride layer combinations and two non-inventive Examples of first and second metal nitride layer combinations. T is the total thickness of the hard material layer. In all examples, the first metal nitride layer was the upper layer and the second metal nitride layer was the lower layer. In all examples, the ratio of the thickness of the first metal nitride layer and the second metal nitride layer was 1:2.

### Non-inventive layer combinations:

Layer combination of Examples 10_1 + 1_2 (T = 2.7 µm)
Layer combination of Examples 8_1 + 13_2 (T = 2.4 µm)

### Inventive layer combinations:

Layer combination of Examples 5_1 + 3_2 (T = 1.8 µm)
Layer combination of Examples 7_1 + 10_2 (T = 2.0 µm).

Tool lifetime is shown in % relative to the tool lifetime of non-inventive layer combination of Examples 10_1 + 1_2 (in which the first metal nitride layer is non-inventive). The non-inventive layer combination of Examples 8_1 + 13_2 (in which the second metal nitride layer is non-inventive) was similar in lifetime. In contrast, the two inventive layer combinations clearly outperformed the non-inventive layer combinations by a lifetime factor of about 3.

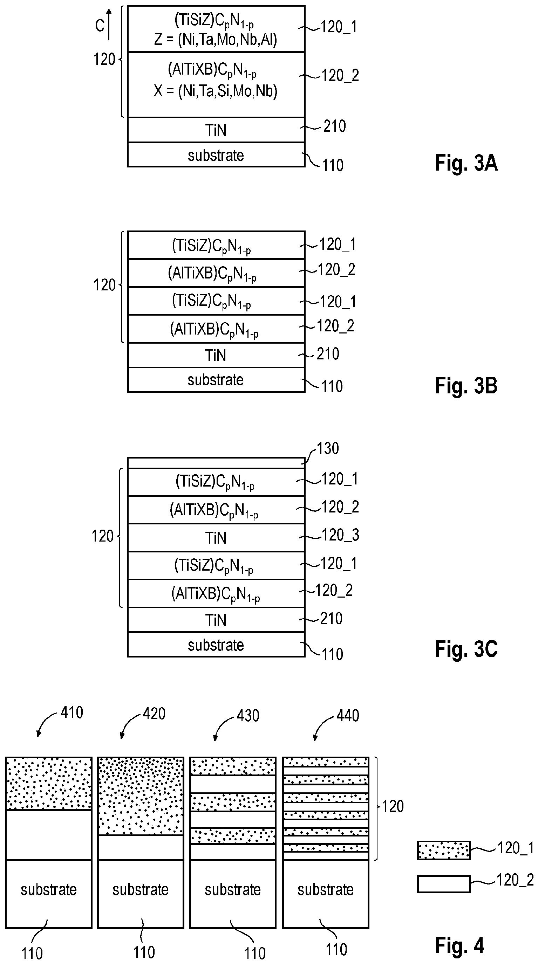

Figures 3A-3C illustrate various illustrative examples of hard material layers 120 which could be used for coating the substrate 110 of a workpiece 100 (see, e.g., Figure 1).

In all examples disclosed herein, the hard material layer 120 is the functional layer of the workpiece 100. Optionally, an adhesion layer 210 may be disposed between the substrate 110 and the hard material layer 120. The adhesion layer 210 may have a composition of TiN, for example.

In the examples of Figures 3A-3C and in all other examples disclosed herein, the hard material layer 120 may have a thickness in a range between 100 nm and 10,000 nm, preferably between 2,000 nm and 4,000 nm. The adhesion layer 210 may have a thickness in a range between 10 nm and 200 nm, preferably about 30 nm.

Referring to Figures 3A-3C, the hard material layer 120 comprises at least one first metal nitride layer 120_1 and at least one second metal nitride layer 120_2 disposed one over the other. The first metal nitride layer 120_1 has a composition as set out in Table 1. The second metal nitride layer 120_2 has a composition as set out in Table 2. The first metal nitride layer 120_1 and the second metal nitride layer 120_2 may each have an approximately stoichiometric nitrogen ratio (within the limits set out above), for example.

Referring to Figure 3A, if two such layers are stacked one over the other, this layer structure may also be referred to as a (functional) bi-layer. The first metal nitride layer 120_1 may be disposed over the second metal nitride layer 120_2. In a bi-layer, the layer thickness of the second metal nitride layer 120_2 may be greater than the layer thickness of the first metal nitride layer 120_1. For example, the thickness of the second metal nitride layer 120_2 may be at least about 1/2, preferred 2/3 of the total thickness of the hard material layer 120, while the layer thickness of the first metal nitride layer 120_1 may be about 1/3 or less of the total thickness of the hard material layer 120.

The first metal nitride layer 120_1 may have a thickness in a range between 100 nm and 3,000 nm. The second metal nitride layer 120_2 may have a thickness in a range between 100 nm and 6,000 nm. For example, the thickness of the second metal nitride layer 120_2 may be, e.g., about 2,000 nm, while the layer thickness of the first metal nitride layer 120_1 may be, e.g., about 1,000 nm.

In some examples, the (upper) first metal nitride layer 120_1 may be monolithic, i.e. may have a composition which is constant along the layer thickness. In other examples, the first metal nitride layer 120_1 may have a composition using a C-gradient (see Figure 3A, arrow C) and/or a Si-gradient.

In a first metal nitride C-gradient layer 120_1, the content p of C in the non-metal lattice CₚN₁₋ₚ increases along a direction facing away from the substrate 110. For example, p may increase from the bottom to the top of the first metal nitride C-gradient layer 120_1 over any of the ranges set out above. For example, the first metal nitride C-gradient layer 120_1 may have a composition which is constant along the layer thickness except for C (and, optionally, Si).

The C-gradient (C content increases towards the surface) may be helpful because C improves the hardness and provides a lubricating effect. Both these effects are particularly beneficial at the surface of the hard material layer 120 (e.g., the surface of the first metal nitride layer 120_1). For example, the C-gradient may extend over the full thickness or over a partial thickness of the first metal nitride layer 120_1.

In a first metal nitride Si-gradient layer 120_1, the content b of Si increases along a direction facing away from the substrate 110. For example, b may increase from the bottom to the top of the metal nitride Si-gradient layer 120_1 over, e.g., any of the ranges set out in Table 1. For example, the first metal nitride Si-gradient layer 120_1 may have a composition which is constant along the layer thickness except for Si (and, optionally, C).

The Si-gradient may be helpful because Si is particularly beneficial at the upper surface of the hard material layer 120 to improve the oxygen diffusion barrier by generating a SiO₂ surface layer which impedes oxygen diffusion into the first metal nitride layer 120_1. Further, such a SiO₂ surface layer has a very high thermal stability. For example, the Si-gradient may extend over the full thickness or over a partial thickness of the first metal nitride layer 120_1.

Si is an optional element in the second metal nitride layer 120_2. If Si is present, the second metal nitride layer 120_2 may (also, for example) be a Si-gradient layer. Reference is made to the above description in connection with the first metal nitride layer 120_1 to avoid reiteration.

The second metal nitride layer 120_2 provides high fracture toughness, i.e. impedes crack propagation, which may more likely occur in the (harder) first metal nitride layer 120_1. Differently stated, the (upper) first metal nitride layer 120_1 is a hard layer, while the (lower) second metal nitride layer 120_2 is a tougher layer.

Further, the (upper) first metal nitride layer 120_1 and the (lower) second metal nitride layer 120_2 have different thermal conductivities. The combination of high and low thermal conductivities produces an anisotropic thermal conductivity which is greater in the lateral direction than in the vertical direction. This protects the substrate 110 from thermal damage and increases the ability of the hard material layer 120 to transfer heat away from the workpiece 100 to the environment by, e.g., the metal chips produced.

Differently stated, the combination of the first metal nitride layer 120_1 and the second metal nitride layer 120_2 may produce many of the desired properties, namely high hardness and high surface lubricity (provided by the first metal nitride layer 120_1) and high fracture toughness (provided by the second metal nitride layer 120_2). Further, the layer interface decreases the thermal conductivity in the direction towards the substrate 110.

Referring to Figure 3B, the bi-layer structure of Figure 3A may be extended to a multi-layer structure having a plurality of alternating first and second metal nitride layers 120_1, 120_2. For example, a large number of alternating first and second metal nitride layers 120_1, 120_2 may be stacked on top of each other (only 4 alternating first and second metal nitride layers 120_1, 120_2 are shown for purpose of illustration). That way, the above-mentioned properties of the respective layers will appear alternately on the surface of the workpiece 100 in the course of abrasive tool operation.

Referring to Figure 3C, the hard material layer 120 may comprise or consist of a plurality of first metal nitride layers 120_1, a plurality of second metal nitride layers 120_2, and at least one and/or a plurality of third metal nitride layers 120_3. The third metal nitride layer(s) 120_3 may be TiN-layer(s). The first metal nitride layers 120_1 and the second metal nitride layers 120_2 may be arranged in alternating order with a third metal nitride layer 120_3 interposed between each first and second metal nitride layer 120_1, 120_2. Alternatively or in addition, a third metal nitride layer 120_3 may be disposed above the alternating first and second metal nitride layers 120_1, 120_2, see Figure 3C.

In other words, the multi-layer structure of Figure 3B may be extended to the multi-layer structure of Figure 3C by providing intermediate third metal nitride layers 120_3 between first and second metal nitride layers 120_1, 120_2. The (optional) intermediate third metal nitride layers 120_3 may have a substantially smaller layer thickness (e.g., by a factor of at least 3, 5, or 10) than the first and the second metal nitride layer 120_1, 120_2.

In the multi-layer structure of Figure 3C, the first metal nitride layer 120_1 may have a thickness in a range between, e.g., 1 nm and 300 nm. Preferably, the layer thickness may be, e.g., about 100 nm.

The second metal nitride layer 120_2 may have a thickness in a range between, e.g., 1 nm and 300 nm. Preferably, the layer thickness may be, e.g., about 100 nm.

The intermediate third metal nitride layer 120_3 may have a thickness in a range between, e.g., 1 nm and 100 nm. Preferably, the thickness may be, e.g., about 10 nm.

In all examples (bi-layer of Figure 3A, multi-layer of Figures 3B-3C), the (uppermost) first metal nitride layer 120_1 may be disposed above the (uppermost) second metal nitride layer 120_2.

All of the hard material layers 120 described above may be provided with an optional decorative top coating 130 (only shown in Figure 3C). The decorative top coating 130 may comprise or consist of, for example, Ti(O,C,N). TiN, for example, results in a golden coating. With a Ti(O,N) coating, the color can be adjusted by the oxygen content. A Ti(C,N) coating has a pink color. The (optional) decorative top coating 130 may have a layer thickness in a range between, e.g., 10 nm and 1,000 nm. Preferably, the layer thickness may be, e.g., about 100 nm.

The multi-layer approaches (Figures 3B-3C) may improve the lifetime of the workpiece 100 compared to the bi-layer approach (Figure 3A) with the same total thickness of the hard material layer 120. Further, they may have better and more uniform thermal, oxidation-resistive and lubricating properties. In particular, the high number of layer boundaries effectively enhances the anisotropy of thermal conductivity. Hence, the multi-layer approach (Figures 3B-3C) may better allow combining the desired property of low thermal conductivity with hardness (abrasion resistance) and fracture toughness (crack propagation resistance).

All of the hard material layers 120 described above, as well as the first metal nitride layer 120_1 and the second metal nitride layer 120_2, may each have their respective composition according to any of the ranges shown in Tables 1 to 4.

Figure 4 illustrates various layer architectures in connection with Figures 3A-3C. The bi-layer architecture of Figure 3A is referred to by reference sign 410. The C- and/or Si-gradient layer architecture of Figure 3A is referred to by reference sign 420. The multi-layer architectures of Figures 3B and 3C (alternating functional layers 120_1, 120_2 without or with intermediate layers 120_3) are referred to by reference sign 430 or, if configured as nano layers (e.g., with a layer thickness equal to or less than 50, 30 or 10 mm), by reference sign 440. The multi-layer architectures 430, 440 of Figures 3B and 3C are schematic illustrations and may, in practice, include in total more than 10, 50, 100, 300 or 500 metal nitride layers (namely, first metal nitride layers 120_1 and second metal nitride layers 120_2 and (optionally) third metal nitride layers 120_3 (not shown)), for example.

As mentioned above, each of the layer architectures 410, 420, 430, 440 may be provided with a lower adhesion layer 210 between the substrate 110 and the hard material layer 120 and/or an optional decorative top coating 130, which are not shown in Figure 4.

Generally, the hard material layer 120 disposed over the substrate 110 may include further material layers, i.e. the presence of additional material layers in the hard material layer 120 is not excluded. In other examples, the hard material layer 120 is composed of the first and second metal nitride layers, the (optional) adhesion layer(s) 210 and the (optional) top coating 130.

A method of manufacturing a workpiece comprising a substrate and a hard material layer as described above may use a PVD (Physical Vapor Deposition) process to generate the adhesion layer 210, the hard material layer 120, and the top coating 130 over the substrate 110. Specifically, cathodic arc deposition and/or sputtering and/or magnetron deposition may be used, for example. Alternatively or in addition, the process may include CVD (Chemical Vapor Deposition) or PECVD (Plasma Enhanced Chemical Vapor Deposition) since, e.g., in particular Si, B, Ti, C can be added via the gas phase. For example, CVD or PECVD can be used to produce gradient layers as described herein by gradually increasing the flow rate of the respective precursor gas (e.g., silane or carbon-hydrogen composition) during layer deposition. Further, the process may additionally include ALD (Atomic Layer Deposition), for example.

In some examples, the substrate 110 may be preheated before starting PVD and/or CVD. That way, the compressive stress in the hard material layer 120 may be reduced by ensuring good CTE (Coefficient of Thermal Expansion) compensation between the substrate 110 and the adhesion layer 210 and/or the hard material layer 120. On a microscopic scale, the intrinsic compressive stress in the hard material layer 120 may be reduced by aiming, e.g., for an (ideally) stoichiometric composition, i.e. by providing a low defect concentration.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A workpiece comprising:
a substrate, and
a hard material layer disposed over the substrate, wherein the hard material layer comprises
at least one first metal nitride layer and at least one second metal nitride layer disposed one over the other,
the first metal nitride layer having a composition (Tiₐ,Si_{b},Z_{z})CₚN₁₋ₚ with optionally added alloying elements Z = (Ni,Ta,Mo,W,Nb,Al), with
0 ≤ Ni ≤ 9 at.%,
0 ≤ Ta ≤ 15 at.%,
0 ≤ Mo ≤ 15 at.%,
0 ≤ W ≤ 10 at.%,
0 ≤ Nb ≤ 15 at.%,
0 ≤ Al ≤ 40 at.%, and
the second metal nitride layer having a composition (Al_{c},Ti_{d},Xₓ,Bₑ)CₚN₁₋ₚ, with optionally added alloying elements X = (Ni,Ta,Si,Mo,W,Nb), with
0 ≤ Ni ≤ 20 at.%,
0 ≤ Ta ≤ 15 at.%,
0 ≤ Si ≤ 30 at.%,
0 ≤ Mo ≤ 12 at.%,
0 ≤ W ≤ 10 at.%,
0 ≤ Nb ≤ 15 at.%, wherein
0.50 ≤ a ≤ 0.90, 0.05 ≤ b ≤ 0.32, 0.30 ≤ c ≤ 0.72, 0.20 ≤ d ≤ 0.50, 0.01 ≤ e ≤ 0.07,
the compositions of the first metal nitride layer and the second metal nitride layer are approximately stoichiometric,
C can be partially or completely replaced by O,
and
0.00 ≤ p ≤ 0.05 for the first metal nitride layer and 0.00 ≤ p ≤ 0.05 for the second metal nitride layer.

2. The workpiece of claim 1, wherein the composition of the first metal nitride layer fulfils one or more of the following requirements:
0.60 ≤ a ≤ 0.85, 0.10 ≤ b ≤ 0.30.

3. The workpiece of claim 1 or 2, wherein the composition of at least one of the first metal nitride layer and the second metal nitride layer contains Ni.

4. The workpiece of any of the preceding claims, wherein the composition of the first metal nitride layer fulfils one or more of the following requirements:
1 ≤ Ni ≤ 6 at.%,
1 ≤ Ta ≤ 12 at.%,
1 ≤ Mo ≤ 5 at.%,
1 ≤ W ≤ 7 at.%,
1 ≤ Nb ≤ 13 at.%,
1 ≤ Al ≤ 35 at.%

5. The workpiece of any of the preceding claims, wherein the composition of the second metal nitride layer fulfils one or more of the following requirements:
0.50 ≤ c ≤ 0.69, 0.23 ≤ d ≤ 0.39, 0.02 ≤ e ≤ 0.06.

6. The workpiece of any of the preceding claims, wherein the composition of the second metal nitride layer fulfils one or more of the following requirements:
2 ≤ Ni ≤ 12 at.%,
1 ≤ Ta ≤ 12 at.%,
1 ≤ Si ≤ 20 at.%,
1 ≤ Mo ≤ 7 at.%,
1 ≤ W ≤ 7 at.%,
1 ≤ Nb ≤ 12 at.%

7. The workpiece of any of the preceding claims, wherein an uppermost first metal nitride layer is disposed above an uppermost second metal nitride layer.

8. The workpiece of any of the preceding claims, wherein first metal nitride layer has a content p of C which increases along a direction facing away from the substrate.

9. The workpiece of any of the preceding claims, wherein the first metal nitride layer and/or the second metal nitride layer has a content of Si which increases along a direction facing away from the substrate.

10. The workpiece of any of the preceding claims, wherein the hard material layer comprises one first metal nitride layer and one second metal nitride layer, wherein the one first metal nitride layer is disposed over the one second metal nitride layer.

11. The workpiece of any of the claims 1 to 9, wherein
the hard material layer comprises a plurality of the first metal nitride layers and a plurality of the second metal nitride layers, and
the first metal nitride layers and the second metal nitride layers are arranged in alternating order.

12. The workpiece of any of the preceding claims, wherein the hard material layer further comprises an adhesion layer, wherein the adhesion layer is arranged between the substrate and the lowermost second metal nitride layer.

13. The workpiece of any of claims 1 to 11, wherein
the hard material layer comprises a plurality of the first metal nitride layers, a plurality of the second metal nitride layers, and at least one adhesion layer,
the first metal nitride layers and the second metal nitride layers are arranged in alternating order with the adhesion layer interposed therebetween or disposed above the alternating first and second metal nitride layers.

14. The workpiece of claim 12 or 13, wherein the adhesion layer comprises a TiN layer.

15. A method of manufacturing a workpiece comprising a substrate and a hard material layer disposed over the substrate according to any of the preceding claims, the method comprising:
using physical vapor deposition and/or chemical vapor deposition to generate the hard material layer over the substrate.
